# EUROPÄISCHE PATENTSCHRIFT

(11) **EP 2 337 102 B1**
(45) Veröffentlichungstag und Bekanntmachung des Hinweises auf die Patenterteilung: **22.05.2013**
(21) Anmeldenummer: 09306228.9
(22) Anmeldetag: 15.12.2009
(51) Int. Cl.: H01L 39/14, H01L 39/24

(54) **Verfahren zur Herstellung eines supraleitfähigen elektrischen Leiters und supraleitfähiger Leiter**
Superconducting conductor and method for producing a superconducting electric conductor
Procédé de fabrication d'un supraconducteur électrique et supraconducteur

(43) Veröffentlichungstag der Anmeldung: 22.06.2011
(73) Patentinhaber: Nexans, 75008 Paris (FR)
(72) Erfinder: Dr. Soika, Rainer, 30559, Hannover (DE); Dipl.-Ing. Schmidt, Frank, 30855, Langenhagen (DE)
(74) Vertreter: Döring, Roger

(56) Entgegenhaltungen:
- EP-A1- 2 131 407
- WO-A1-03/071611
- DE-C1- 19 757 331

## Beschreibung

Die Erfindung bezieht sich auf ein Verfahren zur Herstellung eines supraleitfähigen elektrischen Leiters, der als supraleitfähiges Material ein keramisches Material aufweist sowie auf einen supraleitfähigen Leiter (EP 1 916 720 B1).

Ein mit dem Verfahren nach der Erfindung herzustellender supraleitfähiger elektrischer Leiter besteht aus einem Verbundwerkstoff, dessen supraleitfähiges keramisches Material bei ausreichend tiefen Temperaturen in den supraleitfähigen Zustand übergeht. Der elektrische Gleichstromwiderstand eines aus einem solchen Material aufgebauten Leiters ist bei ausreichender Kühlung Null, solange eine bestimmte Stromstärke nicht überschritten wird. Geeignete keramische Materialien sind beispielsweise BSCCO (Wismut-Strontium-Kalzium-Kupfer-Oxid) oder ReBCO (Rareearth-Barium-Kupfer Oxid), insbesondere YBCO (Yttrium-Barium-Kupfer-Oxid). Ausreichend niedrige Temperaturen, um ein derartiges Material in den supraleitfähigen Zustand zu bringen, liegen beispielsweise zwischen 67 K und 110 K. Geeignete Kühlmittel sind beispielsweise Stickstoff, Helium, Neon und Wasserstoff oder Gemische dieser Stoffe.

Die US-A-5 739 086 beschreibt unterschiedliche Verfahren zur Herstellung von bandförmigen, als Hochtemperatur-Supraleiter bezeichneten elektrischen Leitern. Bei einem BSCCO-Supraleiter wird das BSCCO-Material beispielsweise in Pulverform in ein Rohr aus Silber eingefüllt und verdichtet. Durch mechanische Verformung des Rohres und anschließende Wärmebehandlung (Glühen) wird der supraleitfähige Zustand erreicht. Beim YBCO-Supraleiter, der wegen seiner hervorragenden elektrischen Eigenschaften besonders für elektrische Kabel und Wicklungen geeignet ist, wird auf ein beispielsweise biaxial texturiertes Band aus Metall als Substrat zunächst eine ebenfalls aus Metall bestehende Pufferschicht aufgebracht, auf welche anschließend das YBCO-Material aufgetragen wird. Das Substrat besteht beispielsweise aus Nickel, Kupfer oder Eisen oder einer Legierung dieser Materialien. Für die Pufferschicht werden beispielsweise Kupfer oder Silber eingesetzt. Das YBCO-Material wird abschließend ebenfalls durch Wärmebehandlung in den supraleitfähigen Zustand gebracht. Der so hergestellte supraleitfähige Leiter kann - wie schon erwähnt - mit Vorteil in elektrischen Kabeln sowie Wicklungen für elektrische Motoren und Magnete eingesetzt werden. Er kann dabei aber wegen seiner Bandform nur in einer Richtung gebogen werden.

Mit dem Verfahren nach der eingangs erwähnten EP 1 916 720 B1 wird ein runder supraleitfähiger Leiter hergestellt, der wie ein herkömmlicher Draht verarbeitet werden kann, ohne daß beim Biegen eine besondere Richtung eingehalten werden muß. Mit diesem bekannten Verfahren wird ein als Band vorliegendes, texturiertes metallisches Substrat zunächst in seiner Längsrichtung um einen langgestreckten, metallischen Träger mit kreisförmigem Querschnitt herum zu einem Schlitzrohr mit sich in Längsrichtung erstreckenden, an einem Schlitz aneinander liegenden Kanten geformt. Das Schlitzrohr wird anschließend durch Verschweißen des Schlitzes geschlossen. Das geschlossene Rohr wird danach bis zur Anlage am Träger heruntergezogen. Das supraleitfähige keramische Material wird daraufhin rundum auf das Rohr aufgebracht und abschließend wird eine Wärmebehandlung durchgeführt. Dieses Verfahren hat sich in der Praxis bewährt. Für seine Durchführung ist jedoch ein relativ hoher Aufwand erforderlich. Das außen liegende supraleitfähige Material kann ohne den Einsatz von Zuatzmaßnahmen außerdem leicht beschädigt werden.

Der Erfindung liegt die Aufgabe zugrunde, das eingangs geschilderte Verfahren zu vereinfachen und außerdem sicherzustellen, daß das supraleitfähige Material des mit dem Verfahren hergestellten Leiters gegen mechanische Beschädigungen geschützt ist.

Diese Aufgabe wird gemäß der Erfindung dadurch gelöst,
- daß um eine Vielzahl von flachen Streifen eines mit dem supraleitfähigen keramischen Material beschichteten Trägers ein Metallband längseinlaufend zu einem Rohr mit einem in Längsrichtung verlaufenden Schlitz herumgeformt wird, dessen am Schlitz aneinander liegende Kanten miteinander verschweißt werden,
   und
- daß das durch den Schweißvorgang geschlossene Rohr anschließend auf einen Durchmesser reduziert wird, der etwa der Umhüllenden aller im Rohr befindlichen Streifen entspricht.

Bei Einsatz dieses Verfahrens braucht nur eine Anzahl von Streifen von einem vorgefertigten Band, das einen mit supraleitfähigem Material beschichteten Träger aufweist, abgetrennt und in das Rohr eingebracht zu werden. Das Rohr wird beispielsweise in aus der EP 1 916 720 B1 bekannter Technik aus einem längseinlaufenden Metallband geformt und zu einem geschlossenen Rohr verschweißt. Das geschlossene Rohr wird abschließend so weit in seinem Durchmesser reduziert, bis es die Gesamtheit der Streifen möglichst eng umschließt, ohne daß Druck auf dieselben ausgeübt wird. Das supraleitfähige Material ist im fertigen Leiter innerhalb des Rohrs vor mechanischen Beschädigungen geschützt untergebracht. Der mit diesem Verfahren hergestellte Leiter kann daher ohne besondere Vorsichtsmaßnahmen eingesetzt und mit handelsüblichen Vorrichtungen verarbeitet werden. Wegen der Vielzahl von in dem Rohr befindlichen Streifen mit supraleitfähigem Material ergibt sich der weitere Vorteil, daß der Leiter im Betrieb nur geringe Wechselstromverluste in einem entsprechenden Kabel erzeugt.

Mit Vorteil wird zusätzlich zu den Streifen ein Füllmaterial in das Rohr eingebracht, das zusammen mit den Streifen die lichten Abmessungen des Rohres ausfüllt. Ein solches Material ist vorzugsweise ein bei niedrigen Temperaturen schmelzendes Metall, das im flüssigen oder zähflüssigen Zustand in das noch offene Rohr eingefüllt wird. Es umgibt im fertigen Leiter die Streifen mit dem supraleitfähigen Material in verfestigtem Zustand, so daß eine elektrische Verbindung des Leiters mit anderen elektrischen Leitern mit üblichen Kontaktelementen möglich ist.

Das Verfahren nach der Erfindung und er damit hergestellte Leiter werden anhand der Zeichnungen in Ausführungsbeispielen erläutert.

Es zeigen:
Fig. 1 in schematischer Darstellung eine Vorrichtung zur Durchführung des Verfahrens nach der Erfindung.
Fig. 2 einen Schnitt durch Fig. 1 längs der Linie II - II in vergrößerter Darstellung.
Fig. 3 den Leiter nach der Erfindung in einem Schnitt durch Fig. 1 längs der Linie III - III ebenfalls in vergrößerter Darstellung.
Fig. 4 den Leiter mit einer gegenüber den Fig. 2 und 3 abgewandelten Querschnittsform.

Für den Leiter nach der Erfindung wird als supraleitfähiges Material allgemein ReBCO eingesetzt und insbesondere YBCO, das in der folgenden Beschreibung als spezielles ReBCO-Material berücksichtigt wird.

Die Herstellung von Bändern mit einem Träger, auf dem YBCO abgeschieden ist, geht beispielsweise aus der eingangs erwähnten US-A- 5 739 086 hervor. Derartige Bänder sind auf dem Markt erhältlich. Sie sind beispielsweise zwischen 4 cm und 10 cm breit.

Zur Durchführung des Verfahrens nach der Erfindung wird ein vorgefertigtes mit YBCO beschichtetes Band in Streifen geschnitten, die beispielsweise 0,2 mm bis 4 mm breit sind. Das im folgenden verwendete Wort "Streifen" ist ein derart schmaler flacher Streifen aus einem mit YBCO beschichteten Träger. Diese Streifen können zunächst von einem Band abgetrennt und auf eine Spule aufgewickelt werden. Sie können aber auch im Anschluß an den Trennvorgang direkt weiterverarbeitet werden.

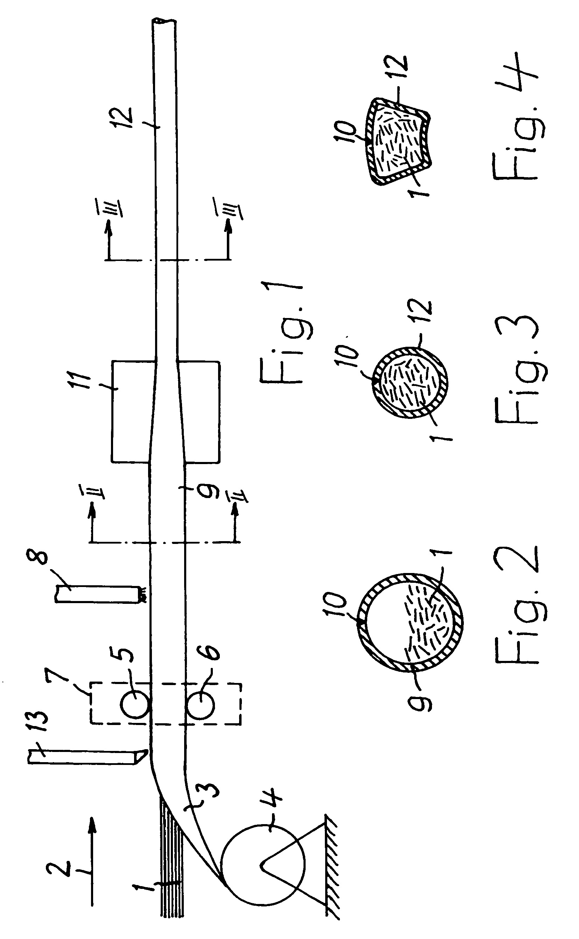

Das Verfahren nach der Erfindung wird beispielsweise wie folgt durchgeführt:
Eine größere Anzahl von Streifen 1 wird mittels einer nicht mit dargestellten Abzugseinrichtung in Richtung des Pfeiles 2 bewegt. Um die Streifen 1 wird ein Metallband 3, das mittels der gleichen Abzugseinrichtung wie die Streifen 1 von einer Spule 4 abgezogen wird, in einer durch zwei Rollen 5 und 6 angedeuteten Formungseinheit 7 längseinlaufend zu einem Rohr mit einem in Längsrichtung verlaufenden Schlitz geformt, an dem die Kanten des Metallbandes 3 aneinander liegen. Der Schlitz wird danach in einer Schweißeinrichtung 8 verschweißt. Das damit geschlossene Rohr 9 geht aus Fig. 2 hervor. Die Streifen 1 liegen im unteren Bereich des Rohres 9, das im oberen Bereich durch eine Schweißnaht 10 verschlossen ist.

Das Metallband 3 kann beispielsweise aus Kupfer, Aluminium oder Edelstahl, aber auch aus einer Legierung, wie beispielsweise Bronze, bestehen.

In einer in Abzugsrichtung (Pfeil 2) folgenden Zieheinheit 11 wird das Rohr 9 auf einen Durchmesser reduziert, der etwa der Umhüllenden aller im Rohr 9 befindlichen Streifen 1 entspricht, so daß es die Streifen 1 nahezu berührt, ohne Druck auf dieselben auszuüben. Der damit fertiggestellte supraleitfähige Leiter 12 geht aus Fig. 3 hervor.

In das noch offene Rohr kann mittels einer Zuführeinheit 13 zusätzlich Füllmaterial in dasselbe eingefüllt werden. Als Füllmaterial wird vorzugsweise ein niedrigschmelzendes Metall verwendet, das im flüssigen bzw. zähflüssigen Zustand in das Rohr eingefüllt wird und bei Raumtemperatur sowie insbesondere bei den niedrigen, zur Erzeugung der Supraleitfähigkeit angewendeten Temperaturen fest ist. Ein solches Metall ist beispielsweise Woodsches Metall, das bei etwa 73 °C bis 77 °C schmilzt, oder Roses-Metall mit einem bei etwa 95 °C liegenden Schmelzpunkt.

Der Leiter 9 bzw. 12 ist gemäß Fig. 2 und 3 kreisrund ausgeführt. Er kann aber auch einen von der Kreisform abweichenden Querschnitt haben, mit einer beispielsweise polygonalen Querschnittsform. Die jeweilige Querschnittsform kann mit Vorteil in der Zieheinheit 11 erzeugt werden. In einer bevorzugten, in Fig. 4 dargestellten Ausführungsform hat der Leiter 12 einen etwa trapezförmigen Querschnitt mit zwei einander gegenüberliegenden gebogenen Seitenflächen. Ein solcher Leiter eignet sich besonders als Einzelelement zum Aufbau eines Leiterseils aus einer Vielzahl solcher Leiter.

## Patentansprüche

1. Verfahren zur Herstellung eines supraleitfähigen elektrischen Leiters, der als supraleitfähiges Material ein keramisches Material aufweist, **dadurch gekennzeichnet,**
- **daß** um eine Vielzahl von flachen Streifen (1) eines mit dem supraleitfähigen, keramischen Material beschichteten Trägers ein Metallband (3) längseinlaufend zu einem Rohr mit einem in Längsrichtung verlaufenden Schlitz herumgeformt wird, dessen am Schlitz aneinander liegende Kanten miteinander verschweißt werden, und
- **daß** das durch den Schweißvorgang geschlossene Rohr (9) anschließend auf einen Durchmesser reduziert wird, der etwa der Umhüllenden aller im Rohr befindlichen Streifen (1) entspricht.

2. Verfahren nach Anspruch 1, **dadurch gekennzeichnet, daß** neben den Streifen (1) Füllmaterial in das Rohr eingefüllt wird.

3. Verfahren nach Anspruch 2, **dadurch gekennzeichnet, daß** als Füllmaterial ein niedrigschmelzendes Metall verwendet wird.

4. Mit dem Verfahren nach Anspruch 1 hergestellter supraleitfähiger, elektrischer Leiter, **dadurch gekennzeichnet, daß** eine Vielzahl von flachen Streifen (1) eines mit supraleitfähigem, keramischem Material beschichteten Trägers in einem aus Metall bestehenden Rohr (12) angeordnet ist, dessen lichter Querschnitt durch die Streifen (1) nahezu vollständig ausgefüllt ist.

5. Leiter nach Anspruch 4, **dadurch gekennzeichnet, daß** er einen kreisrunden Querschnitt hat.

6. Leiter nach Anspruch 4, **dadurch gekennzeichnet, daß** er einen trapezförmigen Querschnitt hat, mit zwei einander gegenüberliegenden gebogenen Seitenflächen.

## Claims

1. Method for the production of a superconductive electrical conductor, which has a ceramic material as the superconductive material, **characterized in**
- **that** a metal ribbon (3) is formed around a plurality of flat strips (1) of a support which is coated with the superconductive ceramic material, running longitudinally to form a tube having a slot which runs in the longitudinal direction, and whose edges which abut to each other at the slot are welded to one another, and
- **that** the tube (9) which is closed by the welding process afterwards is reduced to a diameter which corresponds approximately to the envelope of all the strips (1) which are located in the tube.

2. Method according to claim 1, **characterized in that** filling material is filled into the tube in addition to the strips (1).

3. Method according to claim 2, **characterized in that** a low melting metal is used as the filling material.

4. Superconducting electrical conductor produced by the method according to claim 1, **characterized in that** a plurality of flat strips (1) of a support which is coated with superconductive ceramic material, is placed within a tube (12) of metal and the internal cross section of which is nearly completely filled by the strips (1).

5. Conductor according to claim 4, **characterized in that** it has a circular cross section.

6. Conductor according to claim 4, **characterized in that** it has a trapezoidal cross section with two mutually opposite curved side surfaces.

## Revendications

1. Procédé de fabrication d'un conducteur électrique supraconducteur qui présente un matériau céramique comme matériau supraconducteur,
**caractérisé en ce que**
un feuillard métallique (3) est façonné en longueur en un tube qui présente une fente qui s'étend dans le sens de la longueur autour de plusieurs rubans plats (1) d'un support revêtu par le matériau céramique supraconducteur, les bords de la fente situés l'un contre l'autre étant soudés l'un à l'autre et
**en ce que** le tube (9) fermé par l'opération de soudage est ensuite réduit à un diamètre qui correspond sensiblement à l'enveloppante de tous les rubans (1) situés dans le tube.

2. Procédé selon la revendication 1, **caractérisé en ce qu'**un matériau de charge est introduit dans le tube en plus des rubans (1).

3. Procédé selon la revendication 2, **caractérisé en ce qu'**un métal à bas point de fusion est utilisé comme matériau de charge.

4. Conducteur électrique supraconducteur fabriqué en recourant au procédé selon la revendication 1 et **caractérisé en ce que** plusieurs rubans plats (1) d'un support revêtu du matériau céramique supraconducteur sont disposés dans un tube (12) constitué d'un métal et dont la section transversale intérieure est presque complètement remplie par les rubans (1).

5. Conducteur selon la revendication 4, **caractérisé en ce qu'**il présente une section transversale circulaire.

6. Conducteur selon la revendication 4, **caractérisé en ce qu'**il présente une section transversale trapézoïdale dotée de deux surfaces latérales cintrées et mutuellement opposées.
